Europäisches Patentamt

European Patent Office

Office européen des brevets

(11) Publication number: **0 405 689 A1**

# EUROPEAN PATENT APPLICATION

(21) Application number: 90201696.3

(51) Int. Cl.5: **H01L 21/324**, H01L 21/318

(22) Date of filing: 26.06.90

(30) Priority: 28.06.89 NL 8901637

(43) Date of publication of application:
02.01.91 Bulletin 91/01

(84) Designated Contracting States:
AT BE CH DE DK ES FR GB GR IT LI NL SE

(71) Applicant: GENERAL SIGNAL THINFILM
COMPANY B.V.
Marconistraat 14
NL-7903 AG Hoogeveen(NL)

(72) Inventor: Aite, Kamel
Otto-Klempererstraat 81
NL-7558 EM HENGELO(NL)

(74) Representative: de Bruijn, Leendert C. et al
Nederlandsch Octrooibureau
Scheveningseweg 82 P.O. Box 29720
NL-2502 LS 's-Gravenhage(NL)

(54) Process for removing defects in a metallized semi-conductor device.

(57) Process for removing defects in a metallized semi-conductor material in which a plasma is generated in a flow of ammonia at elevated temperature approximately 300° C. In this process, hydrogen and nitrogen particles are produced which are introduced into the semi-conductor material.

EP 0 405 689 A1

## PROCESS FOR REMOVING DEFECTS IN A METALLIZED SEMI-CONDUCTOR DEVICE.

The invention relates to a process for removing defects in a metallized semi-conductor device, comprising introducing hydrogen particles into the material at low temperature with the aid of a plasma discharge.

Such a method is known from the patent publication DD-A-221,309. This describes the introduction of hydrogen particles into a metallized semi-conductor material at elevated temperature with the aid of plasma techniques. The dimensions of semi-conductor devices are becoming continuously smaller in order to increase integration densities. Such a reduction is achieved by new technologies such as plasma etching, electron beam lithography, X-ray beam lithography, ion etching, sputtering and ion implantation. In all these techniques, undesirable energetic particles, photons or radiation effects are introduced into the devices treated. In addition, the surface of the device is damaged, often to an appreciable extent. Damage introduced into MOS (metal-oxide semi-conductor) structures is usual, such as the generation of fixed charges in the oxide layer, the increase in the surface state at the $SiO_2/Si$ interface, the increase in mobile charge in $SiO_2$ and the generation of neutral crystal faults in the oxide.

These different charge centres may have a close connection with short-range structural faults such as trivalent silicon, non-bridging oxygen and impurities. In the case of an MOS transistor different parameters thereof will be adversely influenced by said faults, such as instability of the threshold value, appreciable surface leakage current and limitation of the slew rate.

Hitherto it was usual to remove such faults by annealing. As a result of this, the faults generated by radiation and other faults were reduced in effect or removed. Thermal annealing is carried out at 400-450°C for 30-60 minutes in nitrogen containing 5-10% hydrogen. In order not to damage the metal layer already deposited, the upper limit of the temperature is limited to 450°C and the time duration to 60 min. This appears in practice not to be sufficient to remove all the defects. In the process proposed in the abovementioned patent specification, a plasma hydrogen treatment is provided at lower temperature (200-300°C) at the end of the diffusion and metallization steps. The disadvantage of this process is that the diffusion of hydrogen into the semi-conductor material cannot be controlled and said diffusion will proceed to saturation, with detrimental effects occurring such as the production of new fault centres. As a result of this, the time of introduction and temperature of introduction of the hydrogen are very critical in this process.

It is the object of the present application to provide a process in which these disadvantages do not exist.

This object is achieved in the process described above in that the introduction of hydrogen particles comprises generating a plasma in a stream of ammonia, nitrogen particles also being introduced into the material. Surprisingly, it has been found that these nitrogen particles together with the semi-conductor material form a sealing layer which forms a seal for the hydrogen. The duration necessary for achieving said sealing layer is sufficient to allow hydrogen to diffuse into the semi-conductor material to a precisely sufficient extent to eliminate the defects present therein. In this manner, controlling the quantity of hydrogen during the plasma process is no longer critical.

In the process, $NH_3$ is split up into nitrogen and hydrogen ions. The explosion hazard is reduced as a result of the presence of nitrogen.

It is pointed out that it is known to use a silicon nitride layer containing hydrogen from European Patent Application 0,152,624, which hydrogen is able to migrate freely into the silicon layer during the annealing and fills crystal faults and prevents other hydrogen escaping. In many devices this technique cannot, however, be used because an additional mask is necessary for it in order to remove the silicon nitride selectively in the contact regions without damaging the metal. In addition, the hydrogen is only released from the silicon nitride film after heating at a temperature higher than 300°C, in which case problems of the mechanical stability of such layers may lead to irreparable damage to the device. The difference from the process according to the invention is the fact that, in the case of the invention, the semi-conductor nitride layer is formed at the same time as the introduction of the hydrogen and a silicon nitride layer containing hydrogen is not formed first, as in the case of said European Patent Specification, and the hydrogen is only then removed from the nitride layer by heating.

German Offenlegungsschrift 3,545,383 discloses a process for wet chemical polishing of silicon wafers. This process cannot be used in the case of devices already treated, as in accordance with the present invention. In accordance with the process followed according to the Offenlegungsschrift, a solution in liquid state or an amide solution is used from which molecular hydrogen is released which diffuses into the silicon during polishing.

According to an advantageous embodiment of the invention, hydrogen and nitrogen are supplied as ammonia, with or without a carrier gas such as nitrogen. The use of ammonia is much safer than the use of $H_2$, for which special measures have to be taken in order to limit the explosion hazard. In addition, no additional mask is necessary in this case. After metallization, the semi-conductor device is subjected to a low- or high-frequency plasma discharge of ammonia. It is assumed that the dissociation reaction of ammonia is as follows:

$$NH_3 \longrightarrow NH + H_2,$$
$$NH_3 \longrightarrow NH_2 + H.$$

From this the presence of atomic hydrogen appears clear. Ionized hydrogen atoms are accelerated towards the surface of the substrate as a result of the voltage built up in the dark space during the discharge. In both the oxide and the interface, hydrogen will react with deep-lying or less deep-lying faults in the semi-conductor material so as to passivate said faults. The faults produced by adding nitrogen as carrier gas owing to the bombardment of the surface of the device by nitrogen ions are easily removed at the annealing temperature used according to the invention.

According to an advantageous embodiment of the application, the semi-conductor material comprises silicon and the aluminium metallization. The treatment temperature is preferably approxima tely 300°C, and the method is therefore applicable to semi-conductor wafers containing devices which are sensitive to high-temperature treatment, for example with silicon wafers metallized with aluminium.

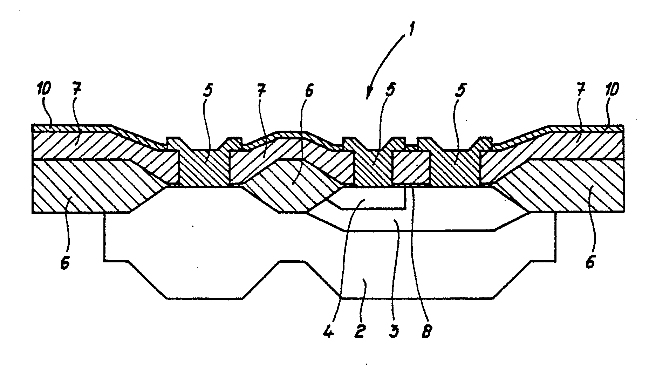

The invention will be discussed below in more detail by reference to an exemplary embodiment of a semi-conductor device shown in the drawing.

In the sole figure, a semi-conductor device, a P-N-P transistor is shown which is generally indicated by 1. This comprises P-type layers 2, 4 and an N-type layer 3. The aluminium metallization is indicated by 5. The oxide layer is indicated by 6, while the boronphosphosilicate glass layer is indicated by 7. During the manufacture of such a semi-conductor, faults may be produced such as by irradiation, and such faults may be situated at a fairly large distance from the surface. Said defects are in this case at the Si-SiO interface, indicated by 6 and 8 and in the implanted regions 2, 3 and 4. Because hydrogen, on the one hand, renders such faults harmless and, on the other hand, diffuses fairly rapidly, this is a material used in the prior art to remove such faults. Because, however, the dosaging of hydrogen cannot be controlled easily, the invention provides for the use of an ammonia plasma. As a result a silicon nitride oxide layer which is indicated by 10 is also produced during the diffusion of hydrogen. At the instant when said silicon nitride oxide layer is complete, hydrogen will no longer be able to diffuse into the semi-conductor device. No nitride layer will be formed on the metal 5.

The invention will be described below with reference to an example. After metallization, the wafers containing the semi-conductor devices produced are subjected to a low- or high-frequency plasma discharge of ammonia with a carrier gas such as nitrogen. The walls of the reactor may or may not be heated. The temperature of the silicon wafers is adjusted between 100 and 450°C. The total gas pressure in the reaction is between 500 and 1000 mtorr. The power density is between 20 and 200 $mW/cm^2$. After 30 minutes, expedient annealing appeared to be achieved. The optical emission of the plasma provided information in relation to the chemical and physical processes which take place in the plasma. From optical emission spectroscopy of the ammonia discharge at 250°C and a frequency of 50 kHz and a total pressure of 650 mtorr, hydrogen appeared to be present in the discharge as a result of the appearance of emission lines corresponding to $H_\alpha$, $H_\beta$ and $H_\gamma$.

Although the invention has been described above with reference to a P-N-P transistor, it must be understood that it is applicable to all types of semi-conductor devices and that the use thereof is not limited to sili-con semi-conductor material and aluminium metallization.

## Claims

1. Process for removing defects in a metallized semi-conductor material, comprising introducing hydrogen particles into the material at elevated temperature with the aid of plasma discharge, characterized in that the introduction of hydrogen particles comprises generating a plasma in a flow of ammonia, nitrogen particles also being introduced into the material.

2. Process according to Claim 1, wherein a carrier gas such as nitrogen is used.

3. Process according to one of the preceding claims, wherein the semi-conductor material comprises silicon.

4. Process according to one of the preceding claims, wherein the metallization comprises aluminium.

5. Process according to one of the preceding claims, wherein the treatment temperature is approximately 300°C.

6. Semi-conductor obtained by the process according to one of the preceding claims.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | DE-A-3 545 383 (WACKER-CHEMITRONIC GESELLSCHAFT FÜR ELEKTRONIK-GRUNDSTOFFE mbH) * Page 2, lines 48-65 * | 1,3 | H 01 L 21/324 H 01 L 21/318 |
| A | US-A-4 602 421 (J.Y. LEE et al.) * Claim 1 * | 1 | |
| A | IEEE ELECTRON DEVICE LETTERS, vol. EDL-5, no. 11, November 1984, pages 468-470, IEEE, New York, US; G.P. POLLACK et al.: "Hydrogen passivation of polysilicon MOSFET's from a plasma nitride source" * Page 468, paragraph II: "Process" * | 1 | |
| D,A | EP-A-0 152 624 (SONY CORP.) * Abstract * | 1 | |
| A | GB-A-2 056 174 (SIEMENS AG) | | |
| A | EP-A-0 022 416 (COMMISSARIAT A L'ENERGIE ATOMIQUE) | | TECHNICAL FIELDS SEARCHED (Int. Cl.5) |
| A | IEEE ELECTRON DEVICE LETTERS, vol. 10, no. 3, March 1989, pages 123-125, IEEE, New York, US; I.-W. WU et al.: "Effects of trap-state density reduction by plasma hydrogenation in low-temperature polysilicon TFT" | | H 01 L |

The present search report has been drawn up for all claims

| Place of search | Date of completion of the search | Examiner |
|---|---|---|
| THE HAGUE | 17-08-1990 | ZOLLFRANK G.O. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)